# EUROPEAN PATENT SPECIFICATION

(11) **EP 3 066 708 B1**
(45) Date of publication and mention of the grant of the patent: **25.07.2018**
(21) Application number: 13792871.9
(22) Date of filing: 08.11.2013
(51) Int. Cl.: H01M 4/58, C01B 25/45, C01B 25/455, H01M 4/36, H01M 4/62, C01B 25/37

(54) **METHOD OF MANUFACTURING AN ELECTRODE MATERIAL, ELECTRODE MATERIAL AND VEHICLE COMPRISING A BATTERY INCLUDING SUCH AN ELECTRODE MATERIAL**
VERFAHREN ZUR HERSTELLUNG EINES ELEKTRODENMATERIALS, ELEKTRODENMATERIAL UND FAHRZEUG MIT EINER BATTERIE MIT SOLCH EINEM ELEKTRODENMATERIAL
PROCÉDÉ DE FABRICATION D'UN MATÉRIAU D'ÉLECTRODE, MATÉRIAU D'ÉLECTRODE ET VÉHICULE COMPRENANT UNE BATTERIE COMPORTANT UN TEL MATÉRIAU D'ÉLECTRODE

(43) Date of publication of application: 14.09.2016
(73) Proprietor: Max-Planck-Gesellschaft zur Förderung der Wissenschaften, 80539 Munich (DE)
(72) Inventor: ZHU, Changbao, 70178 Stuttgart (DE); YU, Yan, 70569 Stuttgart (DE); MAIER, Joachim, 75446 Wiernsheim (DE)
(74) Representative: Manitz Finsterwald Patentanwälte PartmbB
(86) International application number: PCT/EP2013/073370
(87) International publication number: WO 2015/067316

(56) References cited:
- EP-A2- 2 559 655
- DONG-HAN KIM ET AL: "Synthesis of LiFePO4 nanoparticles in polyol medium and their electrochemical properties", ELECTROCHEMICAL AND SOLID-STATE LETTERS, IEEE SERVICE CENTER, PISCATAWAY, NJ, US, vol. 9, no. 9, 11 July 2006 (2006-07-11), pages A439-A442, XP002409829, ISSN: 1099-0062, DOI: 10.1149/1.2218308 cited in the application
- DOMINKO R ET AL: "Porous olivine composites synthesized by sol-gel technique", JOURNAL OF POWER SOURCES, ELSEVIER SA, CH, vol. 153, no. 2, 28 February 2006 (2006-02-28), pages 274-280, XP027937483, ISSN: 0378-7753 [retrieved on 2006-02-28]
- GABERSCEK M ET AL: "Porous, carbon-decorated LiFePO4 prepared by sol-gel method based on citric acid", SOLID STATE IONICS, NORTH HOLLAND PUB. COMPANY. AMSTERDAM; NL, NL, vol. 176, no. 19-22, 1 June 2005 (2005-06-01), pages 1801-1805, XP027742440, ISSN: 0167-2738 [retrieved on 2005-06-01]

## Description

The present invention relates to a method of manufacturing an electrode material having the general formula AₐM_{b}(XY_{(1, 2, 3 or 4)})_{c}, where A is an alkali Metal, or an alkaline earth metal, especially one of Na, Li, K, Ca, Ag, Mg and mixtures thereof, M is a transition metal, which is capable of undergoing oxidation to a higher valence state, especially one of V, Fe, Mn, Co, Ti and Ni or a combination thereof, X is one of P, Si, Ge, B, S, As, Sb and mixtures thereof and Y is one of O, OH, F, CI, Br, I and mixtures thereof. The invention further relates to such an electrode material, to a vehicle comprising a battery including such an electrode material and to a battery.

With the advent of green technologies, such as e.g. electric cars, and green power stations, e.g. solar powered power stations or wind parks etc. the demand for electric storage capabilities is increasing substantially, in order to ensure that no energy shortages takes place due to e.g. the intermittent nature of wind and the time and weather dependence of solar energy. Lithium-based batteries are currently the technology of choice for developing renewable energy technology and electric vehicles due to their high energy density and low weight.

In this connection it should be noted that if electric vehicles are to gain a significant share of future automobile markets, battery production and therefore the demand for lithium will correspondingly grow. Unfortunately lithium is not a readily available resource and with growing demand the price of lithium is increasing. Consequently there is a significant danger of lithium no longer being viable as a commercial resource. For this reason other materials have been considered as an alternative in addition to lithium based electrodes.

The main requirements on a battery for e.g. an electric car or a hybrid car are the cost of the battery. Moreover, the battery cannot be too heavy, because otherwise a larger portion of the power of the battery will be required to accelerate the car of heavier weight. Similarly such a battery needs to have a fast discharge rate, so that during high power peaks, e.g. on acceleration of the car, the car can draw sufficient power from the battery. In this connection it has been found for some materials that too high a discharge rate leads to a breakdown of the storage capability and a failure of the battery. Likewise a battery for such a car requires a fast charge rate, on the one hand, so that owners of the vehicles are not unnecessarily restricted by long charging times and, on the other hand, so that the energy released on braking can also be transformed into battery power (regenerative braking).

One possible alternative battery system is a sodium-ion battery; however, the performance of sodium-ion batteries still leaves much to be desired. The best candidates currently being discussed as cathode materials in sodium-ion batteries are phosphate-based materials because of their thermal stability and higher voltage due to the inductive effect (see the review article by V. Paramaris et al. having the title "Na-ion batteries, recent advantages and present challenges to become low cost energy storage systems" published in Energy & Environmental Science in February 2012).

Consequently, Sodium ion batteries (SIBs) are becoming a potential alternative system which can be applied in the energy storage field, due to the high abundance of Na in the earth, i.e. the very low price of sodium-containing compounds and the similarity of the chemistry between lithium and sodium. Recently, attention has been paid to finding suitable electrode materials for SIBs. For the cathode materials, NaₓCoO₂, Na_{0.44}MnO₂, Na₁₋ₓNi_{0.5}Mn_{0.5}O₂, NaFePO₄, Na₂FePO₄F, Na_{0.6}Fe_{0.5}Mn_{0.5}O₂, Na₄Mn₉O₁₈, NaNi_{1/3}Mn_{1/3}Co_{1/3}O₂, Na₃V₂(PO₄)₃ (also known as NVP) etc. have been extensively investigated.

Independent of the kind of electrode material actually used for the battery different methods of manufacture of the electrode material exist which also influence the capabilities of the electrode material as a battery material. However, since the ionic radius of Na⁺ is large compared to that of Li⁺, a more serious impact on the structure of the host material during insertion-extraction process is observed than for an Li⁺ based process. For this reason it has so far been believed that the methods used to obtain Li based electrode materials are not totally compatible with those used to produce Na based electrode materials.

For this reason so-called solid state methods have been proposed in order to produce Na based electrode materials. However, these solid state methods of preparing an Na based electrode material generally have the side effect that if the sintering process takes too long agglomerations of the electrode material grow which are detrimental to the properties of the electrode material per se.

For this reason J. Kang et. al ("High rate performance of a Na3V2(PO4)3/C" cathode prepared by pyro-synthesis for sodium-ion batteries", published in the Journal of Materials Chemistry 2012, 22, pp. 20857-20860) propose a further process for manufacturing NVP. In this method different precursors are selected than those commonly used in the manufacture of NVP electrodes. Moreover, the sintering time has been reduced to prevent the growth of agglomerations of the electrode material. However, the low intrinsic electronic conductivity of this material limits its electrochemical performance, especially its high rate capability. It is obvious that the pyro-synthesis process will not lead to carbon-coated NVPs having a uniform carbon coating, thus when it discharges at medium C rate (2.67C), the capacity degrades to only half of its theoretical capacity, which is far from the capacity required for industrial applications. In this connection it should be noted that a poor carbon coating can have a more negative impact on the electrode material per se than no carbon coating whatsoever. On the other hand, the complicated procedure of pryo-synthesis is not very easy to reproduce, especially in the large-scale production of electrode materials.

In order to overcome this issue two further types of approaches have been selected. The first approach taken to improve the capabilities of an electrode material is to mix this with a highly conductive material as discussed in the publication by Y. H. Jung et. al ("Graphene-supported Na3V2(PO4)3 as a high rate cathode material for sodium-ion batteries" published in the Journal of Materials Chemistry A, 2013, 1, 11350-11354). In this approach NVP is attached to graphene surfaces, since graphene is an excellent conductor of heat and electricity and should therefore partner well with the NVP. However, since graphene is still one of the most expensive materials present on earth this approach is not industrially viable.

The second approach is discussed in the publication by K. Saravanan et. al ("The First Report on Excellent Cycling Stability and Superior Rate Capability of Na3V2(PO4)3 for Sodium Ion Batteries" published in Advanced Energy Materials 2013, 3, 444-450). In this method a mixture of appropriate surfactants and precursors are mixed with water and ethanol in order to allow for the uniform mixing of the reactants. Following the mixing of the reactants the mixture is heated to 650°C to form an integrated conductive carbon matrix. The material obtained by this process exhibits a good durability and rate performance, however, the larger particle sizes of the NVP and the low conductivity of the carbon at the low sintering temperature used by this approach will limit the rate performance, and it still can not be compared to the lithium battery cathode material, which limits its application e.g. in vehicles.

The publication by Dong-Han Kim et al: "Synthesis of LiFePO4 nanoparticles in polyol medium and their electrochemical properties", published in Electrochemical and Solid-State Letters, vol. 9, no. 9 on July 11, 2006 describes a solvothermal method to prepare LiFePO₄. EP2559655 A2 describes a combustion technique to prepare LiFePO₄. The publication by Dominiko R. et al.: "Porous olivine composites synthesized by sol-gel technique", published in Journal of Power Sources, vol. 153, no. 2 on February 28, 2006, like the publication by Gaberscek M. et. al.: "Porous, carbon-decorated LiFePO4 prepared by sol-gel method on citric acid", published by Solid State Ionics vol. 176, no 19-22 on June 1 2005 describes a sol-gel method to produce LiFePO₄.

It is therefore an object of the present invention to provide a reproducible method of manufacturing an electrode material which has sustainable high charge/discharge rates, at a good storage capacity, and for a good working life, which can operate in a sensible range of operating temperatures and without the need for excessive heating or cooling, so that the battery is mechanically stable.

It is a further object of the present invention to provide a method of manufacturing an electrode material which can be universally applied to different types of electrode materials.

This object is satisfied by a method of manufacture in accordance with claim 1. The dependent claims relate to particularly preferred embodiments of the invention.

In particular the invention relates to a method of manufacturing an electrode material having the general formula AₐM_{b}(XY_{(1, 2, 3 or 4)})_{c}, where A is an alkali Metal, or an alkaline earth metal, especially one of Na, Li, K, Ca, Ag, Mg and mixtures thereof, M is a transition metal, which is capable of undergoing oxidation to a higher valence state, especially one of V, Fe, Mn, Co, Ti and Ni or a combination thereof, X is one of P, Si, Ge, B, S, As, Sb and mixtures thereof and Y is one of O, OH, F, Cl, Br, I and mixtures thereof said method comprising the steps of:
a) selecting precursors for A, M and X,Y, wherein
   a1) the precursors of A, M, especially for M, include compounds of the respective elements and at least the compounds for M containing carbon units in the molecular formula, which will further decompose into carbon
b) selecting at least one of an organic solvent, mixtures of organic solvents and an organic solvent including at least one surfactant which is/are able to at least partly dissolve one of the precursors and is at least miscible with any further precursor; wherein
   b1) the solvent has a boiling point above the decomposition temperature of the precursor for M;
c) mixing the precursors and the solvent for a time sufficient and preferably at room temperature (e.g. at a temperature in the range of ∼20°C to 50 °C) to obtain a homogenous mixture of reactants;
d) heating the mixture to the boiling point of the solvent and refluxing it for a time sufficient to produce a core shell structure comprising particles of AₐM_{b}(XY_{(1, 2, 3 or 4)})_{c} forming cores and coatings of carbon and to provide a further carbon coating on the core shell structure resulting from the capping action of the solvent or surfactant to form nanosized particles having an in-situ double carbon coating on the particles; and
e) separating the particles having the amorphous or crystalline structure from the remainder of the solvent and the precursors; and f) taking the nanosized particles with amorphous or crystalline structure of step e) having a lower conductivity and subjecting this to a post heat treatment step for a time sufficient to crystalize the amorphous structure or to increase the degree of crystallinity such that less defects are present and to increase the electronic conductivity of carbon, wherein the post heat treatment step produces a porous carbon structure which includes the crystalline structures having a higher conductivity.

This method results in nanosized particles with an amorphous or crystalline structure (depending on different materials, for example, the amorphous Na₃V₂(PO₄)₃ and crystalline LiFePO₄ will be obtained) having a in-situ double carbon-coating which results from a process using a facile soft-chemistry based approach. Such a carbon coating (in some cases, further heat-treatment is needed) leads to particularly good conductors and to an increase of the durability and rate performance of the electrode material.

It should be noted that a, b and c in the above equation depend on the valence of the actual element used as an alkali metal, a transition metal and as one of X and Y and that they are selected so as to maintain the electroneutrality of the compound.

Likewise it is possible that the above chemical equation can be rewritten as: AₐM_{b}(XY_{(1, 2, 3 or 4)})_{c}Z_{d}, where Z is OH, a halogen or mixtures thereof and d is also selected to maintain the electroneutrality of the compound. Non limiting examples of the above compounds are NaFePO₄, NaVPO₄F, Na₂FePO₄F, NaVOPO₄, Na₃V₂(PO₄)₂F₃, Na₃V₂(PO₄)₃, LiFePO₄, LiMnPO₄, LiCoPO₄, LiNiPO₄,Li₃Fe₂(PO₄)₃, Li₃V₂(PO₄)₃, Li₂NaV₂(PO₄)₃, LiFe_{0.5}Mn_{0.5}PO₄, Li₂MnSiO₄, Li₂FeSiO₄, LiFeBO₃, LiMnBO₃, Li₂Mn_{0.5}Fe_{0.5}SiO₄.

Typical examples of precursors (M) that can be used are selected from the group comprising organometallic salt, metal alkoxide, metal acetyl acetonate, in particular metal acetyl acetonate. There are VO(C₅H₇O₂)₂, Mn(II) acetyl acetonate, Fe(II) acetyl acetonate, Fe(II) acetate, Fe(II) oxalate, Ti(OC₃H₇-*iso*)₄ Typical examples of precursors (A) are precursors with specific elements, such as Li₂CO₃, LiOH, Li-acetate, Na-acetate, Na₂CO₃, NaOH, KOH, K₂CO₃, MgCO₃, Mg(OH)₂, CaCO₃. Typical examples of precursors (XY) are chosen from the precursors containing X or Y, i.e. H₃PO₄, NH₄H₂PO₄, (NH₄)₂HPO₄. The precursors with both A and XY can also be selected, such LiH₂PO₄, NaH₂PO₄ and NaF.

The organic solvent preferably acts as capping agent or reducing agent. The surfactant preferably acts as capping agent. "Capping agent" refers to a chemical agent that interacts and adheres to the surface of particle and confines the growth of the particle. "Reducing agent" refers to a function of solvent which prevent the oxidation of transition metal precursor during reaction process. Likewise the solvent used can be selected from polyol, which refers to a compound having two or more OH groups in a molecule, such as ethylene glycol, diethylene glycol, triethylene glycol, tetraethylene glycol, 1,2-propylene glycol, 1,3-propylene glycol, glycerin, glycerol, and glucose. Non-limiting examples of the surfactant are long-chain hydrocarbons, polymers, chiral ligands, polycarboxylic acids, polyhydroxy compounds, cationic surfactant, and denrimers, such as poly(vinyl pyrrolidone), polyarylamide, polyacrylic, oleylamine, oleic acid, dodecanethiol, trioctylphosphine, polyvinyl alcohol, polyethylene glycol, ascorbic acid, oxalate, cetyltrimethylammonium bromide, polyamido amine, polyethylenimine.

Advantageously the nanosized particles with amorphous or crystalline structure can be produced at one location and can then be shipped to the manufacturer of the battery for further processing to obtain the final electrode material in dependence on the precise requirements on the battery, this means in dependence on whether the battery is to be used in an electric vehicle, in a hybrid vehicle or in a hand held electronic device which all influence the required size of the cathode.

The post heat-treatment step carried out e.g. results in carbon-coated nanosized Na₃V₂(PO₄)₃ particles which are included (embedded) in a porous carbon matrix (abbreviated as CC-NVP@PCM in the following) when NVP is selected as the cathode material. The cathode material manufactured using this process displays an excellent electrochemical performance with respect to prior art NVP electrodes. In particular an ultrafast charging-discharging of the cathode is enabled. For example, it can be charged or discharged in 6 seconds at a high current density of 22 A/g (200C) and is still able to deliver the specific capacity of 44 mAh/g.

Such a method of manufacture results in a novel type of electrode material having a nanostructure design (i.e. Na₃V₂(PO₄)₃) by combining both of the advantages of using carbon-coated nanosized particles and a porous carbon matrix. This is achieved by using a facile soft-chemistry based method with post heat-treatment.

The ultrahigh rate performance of the material obtained by this method of manufacturer is comparable to that of a supercapacitor, but at a much higher energy density. Moreover, such high rate performance even exceeds that of the most promising lithium battery cathode material (LiFePO₄). Thus this easy-control, low cost synthesis process has a great potential for large-scale production of electrode materials, especially in the production of sodium ion batteries for electric vehicles and hybrid electric vehicles, as well as for static storage applications.

The porous carbon structure that includes the crystalline structures having a higher conductivity facilitates the flow of electrolyte throughout the battery electrode resulting in an increase in the charge capacity of the electrode material and an increase in the charge/discharge rate capabilities of the electrode, in particular with respect to Na⁺ ions whose ionic radius is large compared to that of Li⁺.

In an advantageous embodiment the post heat treatment step is carried out in a gas atmosphere containing a mixture of an inert gas and a reducing gas at a first temperature in order to achieve a desired phase and crystal size, wherein the desired crystal size is an average crystal size preferably in the range of 20 to100nm; preferably in the range of 20 to 50 nm. Incorporating a reducing gas in the gas atmosphere prevents a valence change of M - the transition metal - e.g. if V(III) is used and also hinders the growth of too large agglomerations of the crystallized structure which would prevent the positive side effects of the porous carbon matrix from being utilized, since too large agglomerations hinder the diffusion of Na+ ions throughout the electrode.

In an advantageous embodiment the post heat treatment step is carried out in an inert gas atmosphere at a second temperature to further increase the conductivity of carbon and further improve the crystalline degree with less defects. Subjecting the as-prepared sample to an inert gas atmosphere at a preferably elevated temperature beneficially facilitates the crystallization of the material and leads to the formation of a porous carbon matrix with high conductivity.

Such a combined porous carbon matrix having pores e.g. in the size range of 2 to 5 nm and the particles of NVP being included therein means that electrolyte can be transported throughout the electrode enhancing the storage capacities and the charge/discharge rate of the battery. Moreover, such a carbon matrix is a good conductor of heat and electricity and the battery is capable of showing similar effects to those in which graphene is used.

In a very advantageous embodiment the post heat treatment step is a two step post heat treatment step in which the first step is carried out in a gas atmosphere containing a mixture of an inert gas and a reducing gas at the first temperature followed by a second step which is in an inert gas atmosphere at the second temperature, wherein the second temperature is higher than the first temperature. Such a two step post heat treatment step advantageously combines the individual advantages obtainable using just one post heat treatment step.

In this connection it should be noted that the average particle size following the first heat treatment step is typically in the range of 20-50 nm and preferably centered around 35 nm. Moreover, the average particle size following the second heat treatment step is typically in the range of 40 to 80 nm and preferably centered around 55 nm.

In an advantageous embodiment the solvent or solvent with surfactant is also selected such that it acts as a reducing and a capping agent which reduces the oxidation of M and caps the nanosized particles. The carbon layer from solvent or surfactant is produced on the nanosized particles (preferably with post heat-treatment). This layer acts as both a conductor when the nanosized particles with amorphous or cystalline structure has been further crystallized and thereby enhances the electronic properties of the electrode material and also ensures a good bond between the crystallized structure and the porous carbon matrix.

In an advantageous embodiment the in-situ double carbon-coating process will inhibit the growth of excessively large crystalline structures during the post heat treatment process, by maintaining crystalline structures having an average size in the range of 40 to 100 nm. Limiting the growth of excessively large crystalline structures increases the accessible surface area of the electrode material and improves the flow of electrolyte through the electrode.

In an advantageous embodiment the post heat treatment serves to ensure that the crystalline structures are covered with a carbon layer having a thickness in the range of 1 to 10 nm. This size of carbon layer ensures good electrical properties of the electrode material.

In an aspect of the invention this relates to an electrode material obtainable by means of a method as described herein. Such an electrode material can be used in a battery in which high charge/discharge rates are required.

A further aspect of the invention relates to an electrode material, optionally having been subjected to a post heat treatment process, comprising particles having the general composition of AₐM_{b}(XY₄)_{c}, where A is an alkali Metal, or an alkaline earth metal, especially one of Na, Li, K, Ca, Ag, Mg and mixtures thereof, M is a transition metal, which is capable of undergoing oxidation to a higher valence state, especially one of V, Fe, Mn, Co, Ti and Ni or a combination thereof, X is one of P, Si, Ge, B, S, As, Sb and mixtures thereof and Y is one of O, OH, F, CI, Br, I and mixtures thereof said particles being coated with material comprising carbon and having an average size in the range of 40 to 100 nm and said particles being contained in a porous carbon matrix, and wherein the electrode material has a carbon coating having a thickness in a range of 1 to 10 nm. In a further embodiment the electrode material comprises a BET surface area of greater than 100 m²/g, preferably in the range of 100 to 250 m²/g. This surface area permits an advantageous flow of the electrolyte within the electrode and hence increases the charge capacity of a battery as well as the charge/discharge rates of the battery when the electrode is installed in a battery.

In a further embodiment the electrode material has a carbon coating having a thickness of preferably less than 5 nm. Such a thickness ensures good electronic and heat conductive properties of the battery. Advantageously the capacity of the electrode material is greater than 70 and 40 mAh/g at a current rate of 100 and 200C, respectively and the capacity can maintain higher than 50 mAh/g after 1000 charge-discharge cycles at 100C rate. This cathode material displays an excellent electrochemical performance, especially ultrafast charging-discharging of the cathode is enabled. This means it can be charged or discharged very rapidly and at the same time can deliver a fairly large specific capacity of preferably greater than e.g. 44 mAh/g (200C). This is the best rate performance compared to the results in the prior art.

In a further aspect the invention relates to a vehicle comprising a battery having an electrode material obtainable by means of the method in accordance with the invention. Such a vehicle can be quickly recharged because of the high C-rates that are possible with the electrode material of the invention. Equally good acceleration can be achieved because of the high C discharge rates that are possible.

In a further aspect the invention relates to a battery having a cathode comprising an electrode material in accordance with the invention, an anode, an electrolyte and a separator disposed between the anode and the cathode.

The invention will be described in the following by way of embodiments in detail with reference to the Drawing, in which is shown:
- Fig. 1: a schematic comparison of prior art solid-state process for microsized carbon-coated Na₃V₂(PO₄)₃ (Fig. 1a) and the facile softchemistry-based in-situ double-coating approach used in accordance with the present invention to form CC-NVP@PCM (carbon-coated NVP included in a porous carbon matrix);
- Fig. 2: (a) XRD patterns of the amorphous structure of as-prepared Na₃V₂(PO₄)₃, Na₃V₂(PO₄)₃ sintered at 650 °C in Ar/H₂ and Na₃V₂(PO₄)₃ sintered at 650 °C in Ar/H₂ followed by sintering at 800 °C for in Ar, (b) Nitrogen adsorption/desorption isotherms of CC-NVP@PCM nanocomposite, wherein the inset of Fig. 2b shows the pore-size distribution plot calculated by the BJH method in the adsorption branch isotherm;
- Fig. 3: (a) and (b) SEM images of CC-NVP@PCM sintered at 650 °C in Ar/H₂ and CC-NVP@PCM sintered at 650 °C in Ar/H₂ followed by sintered at 800 °C for in Ar;

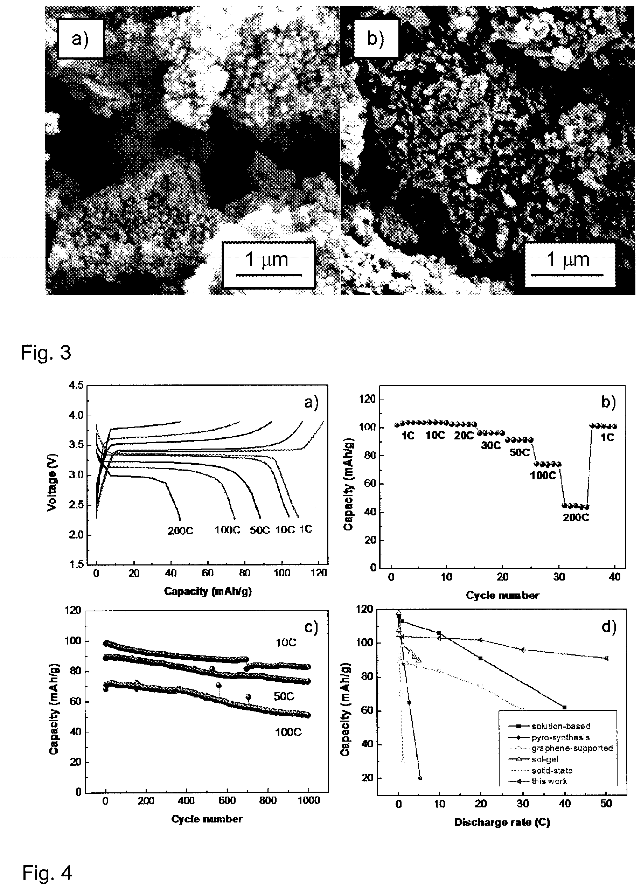

- Fig. 4: the electrochemical characterization of CC-NVP@PCM. (a) Galvanostatic charging-discharging profiles of CC-NVP@PCM at different current rates, (b) excellent high rate performance and capacity retention ability of CC-NVP@PCM, (c) outstanding long cycling stability of CC-NVP@PCM at various high current rates, (d) comparison of rate performance of CC-NVP@PCM to the recently results in the literature for NVP (The solution-based (rectangle), pyro-synthesis (circle), graphene-supported(hollow rectangle), sol-gel(hollow triangle), solid-state methods(hollow circle) are corresponding to references of Saravanan et al, J. Kang et al,Y.H. Jung et al, W. Shen et al, Z. Jian et al. respectively;
- Fig. 5: the high rate performance of CC-NVP@PCM in comparison with carbon-coated LiFePO₄ by the polyol method with the same battery assembly procedure (20% carbon black was added and the loading mass for NVP and LFP are 0.71 and 0.79 mg/cm² respectively), showing the superior fast charging-discharging of CC-NVP@PCM;
- Fig. 6: a differential scanning calorimetry (DSC) curve of vanadium (III) acetylacetonate;
- Fig. 7: charge and discharge profiles of Na₃V₂(PO₄)₃ sintered at 650 °C in Ar/H₂ at 0.5C rate; and
- Fig. 8: charge and discharge profiles of Na₃V₂(PO₄)₃ heat treated at even higher temperature at 0.5C rate (650 °C in Ar/H₂ +800 °C in Ar+ 900 °C in Ar).

Features which have the same or a similar function will be described in the following using the same description. It is also understood that the description relating to one embodiment is also true for the other embodiments unless something is stated to the contrary.

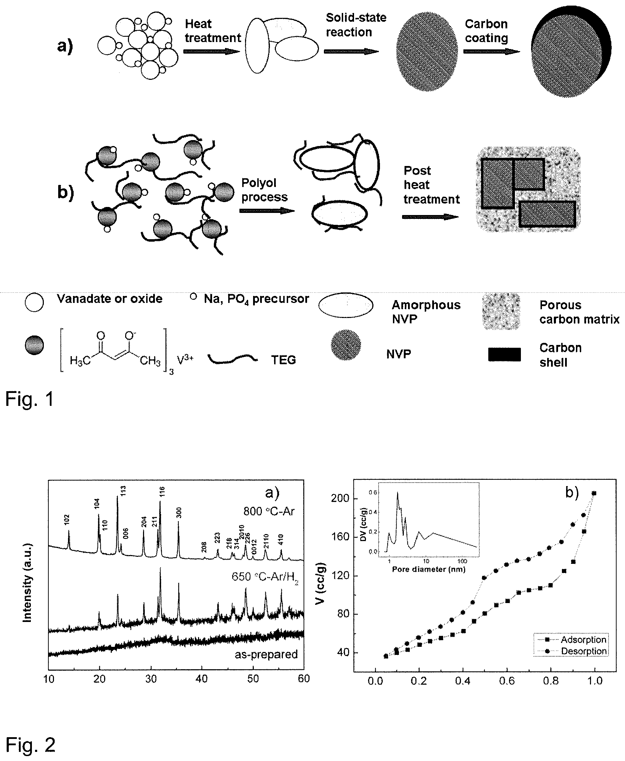

Fig. 1 illustrates an example of the facile fabrication process leading to a promising CC-NVP@PCM architecture in comparison with the conventional solid-state method. In the solid-state approach (Fig. 1a), vanadate (NH₄VO₃) or vanadium oxide (V₂O₃) are typically chosen as a precursor, and during sintering of the mixture of precursors, lead to micro-sized Na₃V₂(PO₄)₃ particles. Post carbon-coating process for these micro-sized particles usually results in inhomogeneous and incomplete carbon coating layers. The inhomogeneous and incomplete carbon coating layers impede the electronic transport in the material and result in polarization.

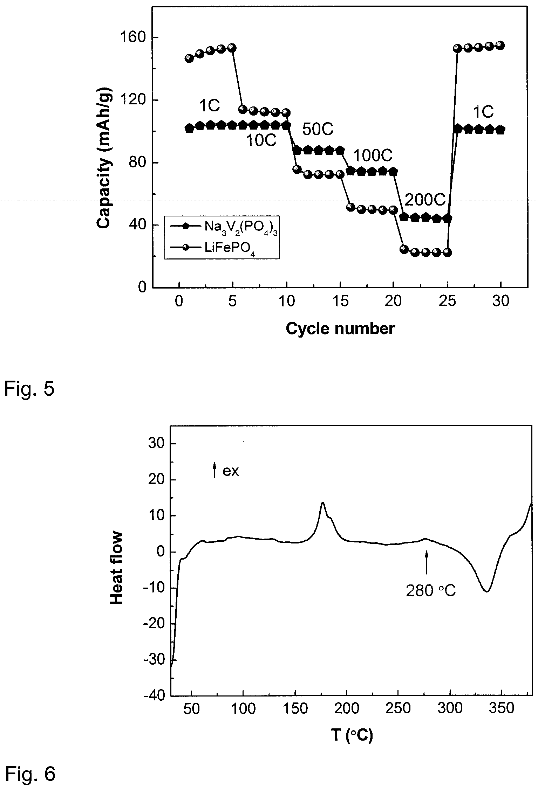

Nonetheless, in the in-situ double carbon-coating process, CC-NVP@PCM can be successfully achieved. Here, VO(C₅H₇O₂)₂ was chosen as vanadium precursor, which will decompose around 280 °C (as shown in DSC, Fig. 6), while in the soft-chemistry process, the system was heated at 320 °C, leading to the amorphous NVP/C core-shell structure. Furthermore, tetraethylene glycol (TEG) is not only used as solvent, but is also advantageously applied as a reducing agent and a capping agent.

As a result, the TEG molecules will cover the surface of the amorphous NVP/C core-shell structure. During the post heat treatment the TEG covered amorphous NVP/C core-shell structure will finally transform to surface-coated carbon layers included in a porous carbon matrix. On the one hand, the in-situ double carbon coating process will prevent particle growth during sintering; on the other hand, the double coating approach achieves homogeneous and perfect thin surface carbon layers and a porous carbon matrix.

### Example 1:

In order to form the carbon-coated nanosized Na₃V₂ (PO₄)₂F₃ the following method of manufacturing an electrode material was used. The precursors NaF, vanadium (III) acetylacetonate (VO(C₅H₇O₂)₂) and ammonium dihydrogen phosphate (NH₄H₂PO₄) were selected and added at a stoichiometric ratio (i.e. 3:2:2). The organic solvent was selected as tetraethylene glycol (TEG) and added to the mixture of precursors, TEG has a boiling point of 320°C. The solution was then stirred for 16 hours at room temperature in order to obtain a homogenous solution. Following the formation of the homogenous solution the solution was heated to 320 °C (note that the temperature is controlled by the thermocouple dipped in the solution, and the system is heated by a sand bath) in a round-bottom flask with magnetic stirring attached to a refluxing condenser for a period of 6 hours. The resultant coated particles (powders) were collected by repeated washing and centrifugation with ethanol and acetone for 3 times respectively, followed by drying in a vacuum oven at 80 °C overnight (∼16 hours).

Following the separation of the powder from the residual precursor and solvent mixture a two step heat treatment test was carried out. In the first step the as-prepared powder was sintered at 650 °C for 6 hours in Ar/H₂ (95:5) and followed by a second step in which a pure Ar atmosphere was used the chamber was heated to 750 °C for 6 hours.

### Example 2:

In order to prepare the carbon-coated nanosized Na₂FePO₄F the following method of manufacturing an electrode material was used. The precursors NaF, Na-CH₃COO, Fe (II) acetylacetonate and ammonium dihydrogen phosphate (NH₄H₂PO₄) were selected and added at a stoichiometric ratio (i.e. 1:1:1:1). The organic solvent was selected as tetraethylene glycol (TEG) and added to the mixture of precursors, TEG has a boiling point of 320°C. The solution was then stirred for 16 hours at room temperature in order to obtain a homogenous solution. Following the formation of the homogenous solution the solution was heated to 320 °C (note that the temperature is controlled by the thermocouple dipped in the solution, and the system is heated by a sand bath) in a round-bottom flask with magnetic stirring attached to a refluxing condenser for a period of 16 hours. The resultant coated particles (powders) were collected by repeated washing and centrifugation with ethanol and acetone for 3 times respectively, followed by drying in a vacuum oven at 80 °C overnight (∼16 hours).

Following the separation of the powder from the residual precursor and solvent mixture a two step heat treatment test was carried out. In the first step the as-prepared powder was sintered at 600 °C for 6 hours in Ar/H₂ (95:5) and followed by a second step in which a pure Ar atmosphere was used the chamber was heated to 650 °C for 6 hours.

### Example 3:

In order to synthesize the carbon-coated nanosized LiMnPO₄ the following method of manufacturing an electrode material was used. The precursors Li-CH₃COO, Mn (II) acetylacetonate and ammonium dihydrogen phosphate (NH₄H₂PO₄) were selected and added at a stoichiometric ratio (i.e. 1:1:1). The organic solvent was selected as tetraethylene glycol (TEG) and oleylamine (1:1 volume ratio) and added to the mixture of precursors, TEG has a boiling point of 320°C. The solution was then stirred for 16 hours at room temperature in order to obtain a homogenous solution. Following the formation of the homogenous solution the solution was heated to 320 °C (note that the temperature is controlled by the thermocouple dipped in the solution, and the system is heated by a sand bath) in a round-bottom flask with magnetic stirring attached to a refluxing condenser for a period of 6 hours. The resultant coated particles (powders) were collected by repeated washing and centrifugation with ethanol and acetone for 3 times respectively, followed by drying in a vacuum oven at 80 °C overnight (∼16 hours).

Following the separation of the powder from the residual precursor and solvent mixture a two step heat treatment test was carried out. In the first step the as-prepared powder was sintered at 600 °C for 4 hours in Ar/H₂ (95:5) and followed by a second step in which a pure Ar atmosphere was used the chamber was heated to 800 °C for 6 hours.

### Example 4:

In order to prepare the carbon-coated nanosized LiFePO₄ the following method of manufacturing an electrode material was used. The precursors Li-CH₃COO, Fe (II) acetylacetonate and ammonium dihydrogen phosphate (NH₄H₂PO₄) were selected and added at a stoichiometric ratio (i.e. 1:1:1). The organic solvent was selected as tetraethylene glycol (TEG) and added to the mixture of precursors, TEG has a boiling point of 320°C. The solution was then stirred for 16 hours at room temperature in order to obtain a homogenous solution. Following the formation of the homogenous solution the solution was heated to 320 °C (note that the temperature is controlled by the thermocouple dipped in the solution, and the system is heated by a sand bath) in a round-bottom flask with magnetic stirring attached to a refluxing condenser for a period of 4 hours. The resultant coated particles (powders) were collected by repeated washing and centrifugation with ethanol and acetone for 3 times respectively, followed by drying in a vacuum oven at 80 °C overnight (∼16 hours).

Following the separation of the powder from the residual precursor and solvent mixture, the as-prepared powder was sintered at 700 °C for 2 hours in Ar/H₂ (95:5).

### Example 5:

In order to synthesize the carbon-coated nanosized Li₃V₂(PO₄)₃ the following method of manufacturing an electrode material was used. The precursors Li-CH₃COO, V (III) acetylacetonate and ammonium dihydrogen phosphate (NH₄H₂PO₄) were selected and added at a stoichiometric ratio (i.e. 3:2:3). The organic solvent was selected as tetraethylene glycol (TEG) and oleylamine (1:1 volume ratio) and added to the mixture of precursors, TEG has a boiling point of 320°C. The solution was then stirred for 16 hours at room temperature in order to obtain a homogenous solution. Following the formation of the homogenous solution the solution was heated to 320 °C (note that the temperature is controlled by the thermocouple dipped in the solution, and the system is heated by a sand bath) in a round-bottom flask with magnetic stirring attached to a refluxing condenser for a period of 6 hours. The resultant coated particles (powders) were collected by repeated washing and centrifugation with ethanol and acetone for 3 times respectively, followed by drying in a vacuum oven at 80 °C overnight (∼16 hours).

Following the separation of the powder from the residual precursor and solvent mixture a two step heat treatment test was carried out. In the first step the as-prepared powder was sintered at 650 °C for 6 hours in Ar/H₂ (95:5) and followed by a second step in which a pure Ar atmosphere was used the chamber was heated to 800 °C for 6 hours.

### Example 6:

In order to form the CC-NVP@PCM the following method of manufacturing an electrode material was used. The precursors sodium acetate (Na-CH₃COO), vanadium (III) acetylacetonate (VO(C₅H₇O₂)₂) and ammonium dihydrogen phosphate (NH₄H₂PO₄) were selected and added at a stoichiometric ratio (i.e. 3:2:3). The organic solvent was selected as tetraethylene glycol (TEG) and added to the mixture of precursors, TEG has a boiling point of 320°C. The solution was then stirred overnight (∼16h) at room temperature in order to obtain a homogenous solution. Following the formation of the homogenous solution the solution was heated to 320 °C (note that the temperature is controlled by the thermocouple dipped in the solution, and the system is heated by sand bath) in a round-bottom flask with magnetic stirring attached to a refluxing condenser for a period of 16 hours. Thereby a core shell structure comprising particles of NVP forming cores and coatings of carbon were obtained and a coating of TEG was produced on the core shell structure. The resultant coated particles (powders) were collected by repeated washing and centrifugation with ethanol and acetone for 3 times respectively, followed by drying in a vacuum oven at 80 °C overnight (∼16h).

Following the separation of the powder from the residual precursor and solvent mixture a two step heat treatment test was carried out. In the first step the as-prepared powder was sintered at 650 °C for 6 hours in Ar/H₂ (95:5) and followed by a second step in which a pure Ar atmosphere was used the chamber was heated to 800 °C for 6 hours.

Fig. 2a displays the X-ray diffraction (XRD) patterns of as-prepared Na₃V₂(PO₄)₃ and the ones sintered at different temperatures and atmospheres. The as-prepared sample after polyol process is amorphous; while the phase-pure, crystalline Na₃V₂(PO₄)₃ was obtained when sintering at 650 °C in Ar/H₂. In order to further increase the conductivity of the carbon, the sample is further heated at 800 °C in Ar, and the pure phase is maintained without any unwanted impurities.

XRD measurements were carried out with a Philips PW 3020 diffractometer using Cu-K_{α} radiation. SEM was performed using JEOL 6300F field-emission scanning electron microscopy (JEOL, Tokyo, Japan) operated at 15 keV. HRTEM was performed by using a JEOL 4000FX transmission electron microscope (JEOL, Tokyo, Japan) operated at 400keV.

In order to investigate the pore structure and surface area of CC-NVP@PCM, a nitrogen isothermal-adsorption technique was applied (Figure 2b), which shows type-IV isotherm with hysteresis loop, indicating nanoporous structure with high surface area of 175 m²/g even after high temperature sintering (800 °C). The BJH pore-size distribution plot (inset of Figure 2b) shows the carbon matrix has mesopores with average pore size is around 3.6 nm in diameter. The carbon content of CC-NVP@PCM is ∼17%wt, as measured by inductively coupled plasma atomic emission spectroscopy (ICP-AES).

The morphology and size of CC-NVP@PCM after sintering at 650 °C and 800 °C were investigated as well. SEM images (Figure 3a and 3b) show microsized clusters having agglomerated nano-sized grains. The grain sizes are around 20-40 nm for CC-NVP@PCM after sintering at 650 °C, and they are slightly increased to 40-100 nm after sintering at 800 °C. Although a few particles with sizes of hundred nanometers are also observed after sintering at 800 °C, which is due to inevitable growth during sintering at elevated temperatures, however, the mean crystalline size of NVP is ∼60 nm, estimated from the width of the strongest peak of (113) by Scherrer's equation.

Furthermore, the NVP nanoparticles disperse very well in the porous carbon matrix, and 2-5 nm thin carbon layers coverer on the surfaces of nanoparticles as also confirmed by TEM technology.

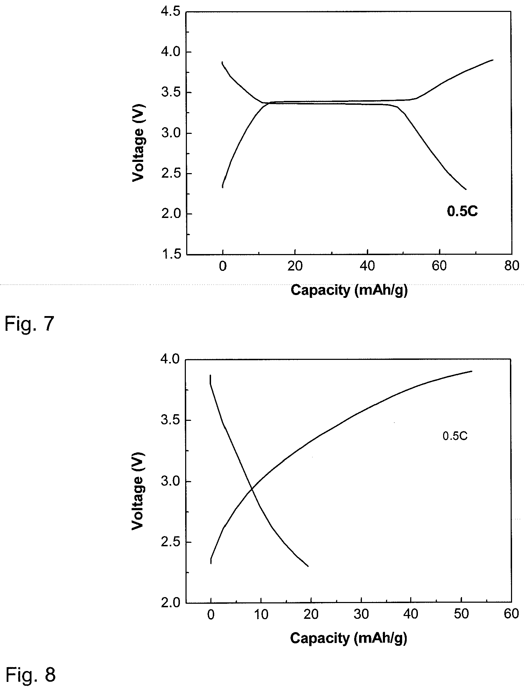

In order to check the potential of CC-NVP@PCM in the high-power SIBs, [CC-NVP@PCM//Na] cells were constructed and tested with an electrochemical window of 2.3-3.9V. For this double carbon-coating process, the temperatures and atmospheres of the post heat-treatment are significant for the electrochemical performance. For CC-NVP@PCM sintered at 650 °C, in spite of smaller particle sizes, due to the low electronic conductivity of carbon, only fair specific capacity can be obtained (Fig. 7). On the other hand, if NVP@PCM is sintered at even higher temperatures (i.e. 900 °C in Ar) to further increase the conductivity of the carbon, unfortunately, the large amount of impurities of phase NaV₃(PO₄)₃ and NaV₂O₅ appear, which damage the specific capacity (even without charge-discharge plateaus) as shown in Fig. 8.

This means that to obtain CC-NVP@PCM having improved electrochemical performance the best post heat treatment process is as follows:
The CC-NVP@PCM is sintered first at 650 °C in an Ar/H₂ atmposphere. This sintering step is followed by sintering at 800 °C in an Ar atmosphere.

Charge and discharge profiles of CC-NVP@PCM at different current densities are shown in Fig. 4a (note that 1C means the full capacity can be charged or discharged in one hour and 1C=110 mA/g in this work). These charge and discharge profiles of CC-NVP@PCM indicate that the CC-NVP@PCM can be charged at ultrafast paces and can be discharged within a very short period of a few seconds, delivering both high energy and high power density, i.e. current density can be increased to as high as 200 C (22 A/g).

The capacity at 200C can be maintained at ∼44 mAh/g (discharge ∼6s). The specific discharge capacities are 104, 103, 102, 96, 91, 74, 44 mAh/g at current rates of 1, 10, 20, 30, 50, 100, 200 C respectively (Figure 4b). The outstanding rate performance demonstrates that if the power density enhances from 430 W/kg to 39 kW/kg (90 times higher), the energy density retains about 66% (from 342 Wh/kg to 227 Wh/kg). Even at very higher power density such as 79 kW/kg, the energy density is still as high as 131 Wh/kg. The capacity retention is also quite impressive, after high rate charge-discharge (200 C), the capacity can still recover to 101 mAh/g at 1C (Figure 4b). This ultrafast rate performance of CC-NVP@PCM is comparable to that of supercapacitor, but with much higher energy density. (Note that for supercapacitor, the power density is around 1-20 kW/kg, but with much less energy density of 1-20 Wh/kg).

The outstanding long cycling stability is observed as well (Fig. 4c). It displays that after 1000 cycles, the capacities are still 83, 73, 51 mAh/g at high current rates of 10C, 50C and 100C, respectively. The results shown herein for a non-aqueous room temperature sodium ion battery have never been reported at such a high rate. The CC-NVP@PCM obtainable by means of the method in accordance with the invention exhibits the highest rate performance compared to the Na₃V₂(PO₄)₃ prepared by other methods in the literature so far (Fig. 4d).

Furthermore, the ultrafast rate performance of CC-NVP@PCM is also comparable or even better to some of the best reported cathode materials for lithium ion batteries with high rate capabilities, such as LiCoO₂, LiMn₂O₄ and LiFePO₄ when prepared using conventional methods.

Generally, it is a difficult task to compare the electrochemical results of materials obtained from different processes because of different electrode preparation procedures, while the factors such as content of conductive carbon, mixing method and time, binder type and amount, loading mass etc. also have an impact on the final performance of the electrode.

For this reason an LiFePO₄ electrode was produced using a prior art polyol method. The thereby obtained LiFePO₄ electrode is known to have a high rate performance. This electrode was subsequently compared to an electrode comprising CC-NVP@PCM using the same battery assembly approach. The high rate performance of this homemade LiFePO₄ is comparable to one of the best results shown in in the literature for this material.

For the electrode preparation, Na₃V₂(PO₄)₃ (70 wt. %), carbon black (20 wt. %, Super-P, Timcal), and poly(vinylidene fluoride) binder (10 wt. %, Aldrich) in N-methylpyrrolidone were mixed. The obtained homogenous slurry was pasted on an Al foil, followed by drying in a vacuum oven for 12 hours at 80 °C. Electrochemical test cells (Swagelok-type) were assembled in an argon-filled glove box (O₂ ≤ 0.1 ppm, H₂O ≤ 1 ppm) with the coated Al foil as a working electrode, sodium metal foil as the counter/reference electrode, and 1 M solution of NaClO₄ in the propylene carbonate (PC) as the electrolyte. Glass fiber (Whatman) was used as separator. The typical loading mass of active material is ∼ 1 mg/cm². The batteries were charged and discharged galvanostatically in the fixed voltage window between 2.3 V to 3.9 V using an Arbin MSTAT battery tester at room temperature. In this work, C rates are used for charactering the current rate, where 1C equals to 110 mA/g. The capacities are calculated based on the mass of Na₃V₂(PO₄)₃ and charge and discharge rates are always identical. Cyclic voltammetry was carried out with a Voltalab system (D21V032, Radiometer Analytical SAS, France) on Swagelok-type cells.

When used in a sodium ion battery all suitable types of electrolytes, anodes and separators can be advantageously used with the cathode material described herein.

The obviously higher rate performance of CC-NVP@PCM in comparison with LiFePO₄ is displayed in Fig. 5. This result shows the potential of CC-NVP@PCM if applied field of electric vehicles and hybrid electric vehicles, even as a substitute for the present lithium ion battery technology.

Ultrafast charge-discharge performance and long cycling stability of CC-NVP@PCM are attributed to the following reasons: i) Nanosized particles effectively decrease the Na diffusion time in the crystal. ii) The homogeneous and complete thin carbon-coating layer on the surface of NVP ensures the fast electron transport between and within the NVP particles. iii) Highly conductive porous carbon matrix with large surface area and mesopores filled by electrolyte facilitates fast charge transfer across the electrolyte/electrode interface, and forms a 3D mix-conducting network, achieving ultrafast charge-discharge performance. iv) The porous carbon matrix can be considered as an elastic buffer in order to release strain caused by volume change during Na insertion and extraction, which delivers stable cycling performance.

In summary, for the first time, we propose and achieve a promising nanostructure design of Na₃V₂(PO₄)₃ through in-situ double carbon-coating process by using a facile soft-chemistry based method with post heat-treatment. The unique morphology of the carbon-coated nanosized Na₃V₂(PO₄)₃ embedded in the porous carbon matrix (CC-NVP@PCM) is successful prepared. The ultrafast charge and discharge properties are outstanding: i.e. it can be charged or discharged in 6 seconds with high current density of 22 A/g, and delivers the specific capacity of 44 mAh/g. This ultrafast rate performance of CC-NVP@PCM is comparable to that of supercapacitor, but with much higher energy density (10 times higher). The excellent high rate performance and long cycling stability even exceeds that of the most promising lithium battery cathode material ----LiFePO₄. The high energy density, especially high power density of CC-NVP@PCM is very crucial for application of electric vehicles or hybrid electric vehicles. In view of much lower price for sodium compound, we anticipate our CC-NVP@PCM to have significant implication in the filed of energy storage, and even replace present lithium technologies. Considering the facile double carbon coating process, this method could also be extended to prepare other cathode or anode materials of lithium or sodium ion batteries.

The following references describe electrode materials and their prior art method of manufacture:
J. M. Tarascon and M. Armand, Nature, 2001, 414, 359.
S.-W. Kim, D.-H. Seo, X. Ma, G. Ceder and K. Kang, Advanced Energy Materials, 2012, 2, 710-721.
V. Palomares, P. Serras, I. Villaluenga, K. B. Hueso, J. Carretero-Gonzalez and T. Rojo, Energy Environ. Sci., 2012, 5, 5884-5901.
R. Berthelot, D. Carlier and C. Delmas, Nature Materials, 2011, 10, 74-U73.
F. Sauvage, L. Laffont, J. M. Tarascon and E. Baudrin, Inorganic Chemistry, 2007, 46, 3289-3294.
S. Komaba, N. Yabuuchi, T. Nakayama, A. Ogata, T. Ishikawa and I. Nakai, Inorganic Chemistry, 2012, 51, 6211-6220.
S.-M. Oh, S.-T. Myung, J. Hassoun, B. Scrosati and Y.-K. Sun, Electrochemistry Communications, 2012, 22, 149-152.
Y. Kawabe, N. Yabuuchi, M. Kajiyama, N. Fukuhara, T. Inamasu, R. Okuyama, I. Nakai and S. Komaba, Electrochemistry Communications, 2011, 13, 1225-1228.
N. Yabuuchi, M. Kajiyama, J. Iwatate, H. Nishikawa, S. Hitomi, R. Okuyama, R. Usui, Y. Yamada and S. Komaba, Nature Materials, 2012, 11, 512-517.
Y. Cao, L. Xiao, W. Wang, D. Choi, Z. Nie, J. Yu, L. V. Saraf, Z. Yang and J. Liu, Adv. Mater., 2011, 23, 3155-+.
M. Sathiya, K. Hemalatha, K. Ramesha, J. M. Tarascon and A. S. Prakash, Chemistry of Materials, 2012, 24, 1846-1853.
B. L. Ellis and L. F. Nazar, Current Opinion in Solid State & Materials Science, 2012, 16, 168-177.
C. Masquelier, C. Wurm, J. Rodriguez-Carvajal, J. Gaubicher and L. Nazar, Chemistry of Materials, 2000, 12, 525-532.
C. Masquelier, A. K. Padhi, K. S. Nanjundaswamy and J. B. Goodenough, J. Solid State Chem., 1998, 135, 228-234.
Z. Jian, L. Zhao, H. Pan, Y.-S. Hu, H. Li, W. Chen and L. Chen, Electrochemistry Communications, 2012, 14, 86-89.
Z. Jian, W. Han, X. Lu, H. Yang, Y.-S. Hu, J. Zhou, Z. Zhou, J. Li, W. Chen, D. Chen and L. Chen, Advanced Energy Materials, 2013, 3, 156-160.
C. Delmas, R. Olazcuaga, F. Cherkaoui, R. Brochu and G. Leflem, Comptes Rendus Hebdomadaires Des Seances De L Academie Des Sciences Serie C, 1978, 287, 169-171.
S. Y. Lim, H. Kim, R. A. Shakoor, Y. Jung and J. W. Choi, Journal of the Electrochemical Society, 2012, 159, A1393-A1397.
W. Shen, C. Wang, H. Liu and W. Yang, Chemistry - A European Journal, 2013, 19, 14712-14718.
R. Dominko, M. Bele, M. Gaberscek, M. Remskar, D. Hanzel, S. Pejovnik and J. Jamnik, Journal of The Electrochemical Society, 2005, 152, A607.
L. Shen, H. Li, E. Uchaker, X. Zhang and G. Cao, Nano Lett., 2012, 12, 5673-5678.
D.-H. Kim and J. Kim, Electrochemical and Solid-State Letters, 2006, 9, A439.
X.-L. Wu, L.-Y. Jiang, F.-F. Cao, Y. G. Guo and L.-J. Wan, Adv. Mater., 2009, 21, 2710-2714.
M. Okubo, E. Hosono, J. Kim, M. Enomoto, N. Kojima, T. Kudo, H. Zhou and I. Honma, Journal of the American Chemical Society, 2007, 129, 7444**.**
E. Hosono, T. Kudo, I. Honma, H. Matsuda and H. Zhou, Nano Lett., 2009, 9, 1045-1051.
K. M. Shaju and P. G. Bruce, Chemistry of Materials, 2008, 20, 5557-5562.
W.-J. Zhang, Journal of The Electrochemical Society, 157, A1040.
C. Zhu, K. Weichert, J. Popovic and J. Maier, To be submitted*.*
F. Cheng, H. Wang, Z. Zhu, Y. Wang, T. Zhang, Z. Tao and J. Chen, Energy Environ. Sci., 2011, 4, 3668-3675.

## Claims

1. A method of manufacturing an electrode material having the general formula AₐM_{b}(XY_{(1, 2, 3 or 4)})_{c}, where A is an alkali Metal, or an alkaline earth metal, , M is a transition metal, which is capable of undergoing oxidation to a higher valence state, X is one of P, Si, Ge, B, S, As, Sb and mixtures thereof and Y is one of O, OH, F, Cl, Br, I and mixtures thereof said method comprising the steps of:
a) selecting precursors for A, M and X, Y, wherein
a1) the precursors of A, M, especially for M, include compounds of the respective elements and at least the compound for M containing carbon units in the molecular formula, which will further decompose into carbon;
b) selecting at least one of an organic solvent, mixtures of organic solvents or an organic solvent including at least one surfactant which is/are able to at least partly dissolve one of the precursors and is at least miscible with any further precursor; wherein
b1) the solvent has a boiling point above the decomposition temperature of the precursor for M ;
c) mixing the precursors and the solvent for a time sufficient to obtain a substantially homogenous mixture;
d) heating the mixture to the boiling point of the solvent and refluxing it for a time sufficient to produce a core shell structure comprising particles of AₐM_{b}(XY_{(1, 2, 3 or 4)})_{c} forming cores and coatings of carbon and to provide a further carbon coating on the core shell structure resulting from the capping action of the solvent or surfactant to form nanosized particles having an in-situ double carbon coating on the particles;
e) separating the nano-particles having the amorphous or crystalline structure from the remainder of the solvent and the precursors; and
f) taking the as-prepared nano-particles with amorphous or crystalline structure of step e) having a lower conductivity and subjecting this to a post heat treatment step for a time sufficient to crystalize the amorphous structure, to increase the degree of crystallinity such that less defects are present, and to increase the conductivity of the carbon; wherein the post heat treatment step produces a porous carbon structure which includes the crystalline structures having a higher conductivity.

2. A method in accordance with claim 1, where A is one of Na, Li, K, Ca, Ag, Mg and mixtures thereof, and M is one of V, Fe, Mn, Co, Ti and Ni or a combination thereof.

3. A method in accordance with claim 1 or claim 2, wherein the post heat treatment step is carried out in a gas atmosphere containing a mixture of an inert gas and a reducing gas at a first temperature in order to achieve a desired crystal size, wherein the desired crystal size is an average crystal size preferably in the range of 40 to 100nm.

4. A method in accordance with any one of the preceding claims, wherein the post heat treatment step is carried out in an inert gas atmosphere at a second temperature to further increase the conductivity of the crystal structure and carbon.

5. A method in accordance with claim 3 and 4, wherein the post heat treatment step is a two step post heat treatment step in which the first step is carried out in a gas atmosphere containing a mixture of an inert gas and a reducing gas at the first temperature followed by a second step which is in an inert gas atmosphere at the second temperature, wherein the second temperature is higher than the first temperature.

6. A method in accordance with any one of the preceding claims, wherein the solvent is also selected such that it acts as a reducing and capping agent which reduces the oxidation of M and caps the nanoparticles of the amorphous or crystalline structure .

7. A method in accordance with claim 6, wherein the capped nanoparticles with amorphous or crystalline structures inhibit the growth of large crystalline structures during the post heat treatment process, by limiting the average size of the crystalline structures to the range of 40 to 100 nm.

8. A method in accordance with any one of the preceding claims, wherein the post heat treatment serves to ensure that the crystalline structures are covered with a carbon layer having a thickness in the range of 1 to 10 nm.

9. A method in accordance with claim 1, wherein the porous carbon structure has pores having an average size in the range of 2 to 5 nm.

10. An electrode material, comprising particles having the general composition of AₐM_{b}(XY₄)_{c}, where A is an alkali Metal, or an alkaline earth metal, M is a transition metal, which is capable of undergoing oxidation to a higher valence state, X is one of P, Si, Ge, B, S, As, Sb and mixtures thereof and Y is one of O, OH, F, Cl, Br, I and mixtures thereof, said particles being coated with material comprising carbon and having an average size in the range of 40 to 100 nm and said particles being contained in a porous carbon matrix and wherein the electrode material has a carbon coating having a thickness in the range of 1 to 10 nm.

11. An electrode material in accordance with claim 10, wherein A is one of Na, Li, K, Ca, Ag, Mg and mixtures thereof, and M is one of V, Fe, Mn, Co, Ti and Ni or a combination thereof.

12. An electrode material in accordance with claim 10 or claim 11, further comprising a BET surface area of greater than 100 m²/g, preferably in the range of 100 to 250 m²/g.

13. An electrode material in accordance with any one of claims 10 to 12, wherein the capacity of the electrode material is greater than 70 and 40 mAh/g at a current rate of 100 and 200C, respectively and the capacity can maintain higher than 50 mAh/g after 1000 charge-discharge cycles at 100C rate.

14. A vehicle comprising a battery having an electrode material obtainable by means of the method in accordance with any one of claims 1 to 9.

15. A battery having a cathode comprising an electrode material obtainable by means of the method in accordance with any one of the claims 1 to 9, an anode, an electrolyte and a separator disposed between the anode and the cathode.

## Patentansprüche

1. Verfahren zum Herstellen eines Elektrodenmaterials mit der allgemeinen Formel AₐM_{b}(XY(_{(1, 2}, _{3 oder 4)})_{c}, wobei A ein Alkalimetall oder ein Erdalkalimetall ist, M ein Übergangsmetall ist, das in der Lage ist, in einen höheren Valenzzustand oxidiert zu werden, X eines aus P, Si, Ge, B, S, As, Sb und Gemischen davon ist und Y eines von O, OH, F, Cl, Br, I und Gemischen davon ist, wobei das Verfahren die Schritte umfasst, dass:
a) Vorstufen für A, M und X, Y gewählt werden, wobei
a1) die Vorstufen von A, M, insbesondere für M, Verbindungen der jeweiligen Elemente umfassen und zumindest die Verbindung für M Kohlenstoffeinheiten in der Molekularformel enthält, die weiter in Kohlenstoff zersetzt werden;
b) zumindest eines aus einem organischen Lösemittel, Gemischen von organischen Lösemitteln oder einem organischen Lösemittel, das zumindest einen oberflächenaktiven Stoff aufweist, der in der Lage ist, zumindest teilweise eine der Vorstufen zu lösen, und zumindest mit einer weiteren Vorstufe mischbar ist, gewählt wird; wobei
b1) das Lösemittel einen Siedepunkt oberhalb der Zersetzungstemperatur der Vorstufe für M aufweist;
c) die Vorstufen und das Lösemittel für eine ausreichende Zeit gemischt werden, um ein im Wesentlichen homogenes Gemisch zu erhalten;
d) das Gemisch auf den Siedepunkt des Lösemittels erhitzt und dieses für eine ausreichende Zeit rückgeführt wird, um eine Kernschalenstruktur zu erzeugen, die Partikel aus AₐM_{b}(XY_{(1, 2, 3 oder 4)})_{c} umfasst, die Kerne und Beschichtungen aus Kohlenstoff bilden, und um eine weitere Kohlenstoffbeschichtung an der Kernschalenstruktur bereitzustellen, die aus der Deckwirkung des Lösemittels oder oberflächenaktiven Stoffes resultiert, um Partikel in Nanogröße zu bilden, die eine vor Ort erfolgende Doppelkohlenstoffbeschichtung auf den Partikeln aufweisen;
e) die Nanopartikel mit der amorphen oder kristallinen Struktur von dem Rest des Lösemittels und den Vorstufen getrennt werden; und
f) die aufbereiteten Nanopartikel mit amorpher oder kristalliner Struktur von Schritt e), die eine geringere Leitfähigkeit aufweisen, genommen werden und einem nachgeordneten Wärmebehandlungsschritt für eine ausreichende Zeitdauer unterzogen werden, um die amorphe Struktur zu kristallisieren und damit den Grad an Kristallinität derart zu erhöhen, dass wenig Defekte vorhanden sind, und um die Leitfähigkeit des Kohlenstoffs zu erhöhen; wobei der nachgeordnete Wärmebehandlungsschritt eine poröse Kohlenstoffstruktur erzeugt, die die kristallinen Strukturen, die eine höhere Leitfähigkeit aufweisen, aufweist.

2. Verfahren nach Anspruch 1,
wobei A eines aus Na, Li, K, Ca, Ag, Mg und Gemischen daraus ist und M eines aus V, Fe, Mn, Co, Ti und Ni oder einer Kombination daraus ist.

3. Verfahren nach einem der Ansprüche 1 oder 2,
wobei der nachgeordnete Wärmebehandlungsschritt in einer Gasatmosphäre ausgeführt wird, die ein Gemisch aus einem Inertgas und einem reduzierenden Gas bei einer ersten Temperatur enthält, um eine gewünschte Kristallgröße zu erreichen, wobei die gewünschte Kristallgröße eine durchschnittliche Kristallgröße bevorzugt im Bereich von 40 bis 100 nm ist.

4. Verfahren nach einem der vorhergehenden Ansprüche,
wobei der nachgeordnete Wärmebehandlungsschritt in einer Inertgasatmosphäre bei einer zweiten Temperatur ausgeführt wird, um die Leitfähigkeit der Kristallstruktur und des Kohlenstoffs weiter zu erhöhen.

5. Verfahren nach einem der Ansprüche 3 und 4,
wobei der nachgeordnete Wärmebehandlungsschritt ein zweistufiger nachgeordneter Wärmebehandlungsschritt ist, bei dem der erste Schritt in einer Gasatmosphäre ausgeführt wird, die ein Gemisch aus einem Inertgas und einem reduzierenden Gas bei einer ersten Temperatur enthält, gefolgt durch einen zweiten Schritt, der in eine Inertgasatmosphäre bei einer zweiten Temperatur erfolgt, wobei die zweite Temperatur höher als die erste Temperatur ist.

6. Verfahren nach einem der vorhergehenden Ansprüche,
wobei das Lösemittel auch so gewählt ist, dass es als ein reduzierendes und bedeckendes Mittel wirkt, das die Oxidation von M reduziert und die Nanopartikel der amorphen oder kristallinen Struktur bedeckt.

7. Verfahren nach Anspruch 6,
wobei die bedeckten Nanopartikel mit amorphen oder kristallinen Strukturen das Wachstum großer kristalliner Strukturen während des nachgeordneten Wärmebehandlungsschrittes durch Begrenzen der durchschnittlichen Größe der Kristallstrukturen auf den Bereich von 40 bis 100 nm hemmen.

8. Verfahren nach einem der vorhergehenden Ansprüche,
wobei die nachgeordnete Wärmebehandlung dazu dient, sicherzustellen, dass die kristallinen Strukturen mit einer Kohlenstoffschicht mit einer Dicke im Bereich von 1 bis 10 nm bedeckt sind.

9. Verfahren nach Anspruch 1,
wobei die poröse Kohlenstoffstruktur Poren mit einer durchschnittlichen Größe im Bereich von 2 bis 5 nm aufweist.

10. Elektrodenmaterial mit Partikeln, die die allgemeine Zusammensetzung von AₐM_{b}(XY₄)_{c} aufweisen, wobei A ein Alkalimetall oder ein Erdalkalimetall ist, M ein Übergangsmetall ist, das in der Lage ist, auf einen höheren Valenzzustand oxidiert zu werden, X eines aus P, Si, Ge, B, S, As, Sb und Gemischen daraus ist und Y eines von O, OH, F, Cl, Br, I und Gemischen daraus ist, wobei die Partikel mit einem kohlenstoffhaltigen Material beschichtet sind und eine durchschnittliche Größe im Bereich von 40 bis 100 nm aufweisen und die Partikel in einer porösen Kohlenstoffmatrix enthalten sind, und wobei das Elektrodenmaterial eine Kohlenstoffbeschichtung mit einer Dicke im Bereich von 1 bis 10 nm aufweist.

11. Elektrodenmaterial nach Anspruch 10,
wobei A eines von Na, Li, K, Ca, Ag, Mg und Mischungen daraus ist und M eines aus V, Fe, Mn, Co, Ci und Ni oder einer Kombination daraus ist.

12. Elektrodenmaterial nach einem der Ansprüche 10 oder 11,
ferner mit einer BET-Oberfläche von größer als 100 m²/g, bevorzugt im Bereich von 100 bis 250 m²/g.

13. Elektrodenmaterial nach einem der Ansprüche 10 bis 12,
wobei die Kapazität des Elektrodenmaterials größer als 70 und 40 mAh/g bei einer Stromrate von 100 bzw. 200 C ist und die Kapazität auf höher als 50 mAh/g nach 1000 Lade-Entlade-Zyklen bei einer Rate von 100 C beibehalten werden kann.

14. Fahrzeug mit einer Batterie, die ein Elektrodenmaterial aufweist, das mittels des Verfahrens nach einem der Ansprüche 1 bis 9 erhaltbar ist.

15. Batterie mit einer Kathode, die ein Elektrodenmaterial umfasst, das mittels des Verfahrens nach einem der Ansprüche 1 bis 9 erhaltbar ist, einer Anode, einem Elektrolyt und einem Separator, der zwischen der Anode und der Kathode angeordnet ist.

## Revendications

1. Procédé de fabrication d'un matériau d'électrode ayant la forme générale : AₐM_{b}(XY_{(1, 2}, _{3 ou 4)})_{c}, dans laquelle A est un métal alcalin ou un métal alcalino-terreux, M est un métal de transition qui est capable de subir une oxydation vers un état à valence plus élevée, X est un élément parmi P, Si, Ge, B, S, As, Sb et leurs mélanges, et Y est un élément parmi O, OH, F, Cl, Br, I et leurs mélanges,
ledit procédé comprenant les étapes consistant à :
a) sélectionner des précurseurs pour A, M et X, Y, tels que
a1) les précurseurs de A, M, spécialement pour M, incluent des composés des éléments respectifs et au moins le composé pour M contient des unités carbone dans la formule moléculaire, qui vont en outre se décomposer en donnant du carbone ;
b) sélectionner au moins un solvant parmi un solvant organique, des mélanges de solvants organiques ou encore un solvant organique incluant au moins un agent tensioactif, qui est/sont capable(s) de dissoudre au moins partiellement l'un des précurseurs et qui est au moins miscible avec un quelconque autre précurseur ; dans lequel
b1) le solvant a un point d'ébullition au-dessus de la température de décomposition du précurseur pour M ;
c) on mélange les précurseurs et le solvant pendant un temps suffisant pour obtenir un mélange sensiblement homogène ;
d) on chauffe le mélange au point d'ébullition du solvant et on le porte au reflux pendant un temps suffisant pour produire une structure à noyau et à coque comprenant des particules de AₐM_{b}(XY_{(1, 2, 3 ou 4)})_{c}, en formant des noyaux et des revêtements de carbone et pour procurer un autre revêtement de carbone sur la structure à noyau et à coque, résultant de l'action de recouvrement du solvant ou de l'agent tensioactif pour former des particules de taille nanométrique ayant un revêtement en carbone double in situ sur les particules ;
e) on sépare les particules nanométriques ayant la structure amorphe ou cristalline vis-à-vis du reste du solvant et des précurseurs ; et
f) on prend les particules nanométriques telles que préparées avec une structure amorphe ou cristalline de l'étape e) ayant une faible conductivité et on les soumet à une étape de post-traitement thermique pendant un temps suffisant pour cristalliser la structure amorphe, pour augmenter le degré de cristallinité de telle sorte qu'il se présente moins de défauts, et pour augmenter la conductivité du carbone ; dans lequel l'étape de post-traitement thermique produit une structure de carbone poreux qui inclut les structures cristallines ayant une conductivité plus élevée.

2. Procédé selon la revendication 1, dans lequel A est un élément parmi Na, Li, K, Ca, Ag, Mg et leurs mélanges, et M est un élément parmi V, Fe, Mn, Co, Ti et Ni ou une combinaison de ceux-ci.

3. Procédé selon la revendication 1 ou 2, dans lequel l'étape de post-traitement thermique est effectuée dans une atmosphère gazeuse contenant un mélange d'un gaz inerte et d'un gaz réducteur à une première température afin d'atteindre une taille de cristaux désirée, telle que la taille de cristaux désirée est une taille moyenne de préférence dans la plage de 40 à 100 nm.

4. Procédé selon l'une quelconque des revendications précédentes, dans lequel l'étape de post-traitement thermique est effectuée dans une atmosphère de gaz inerte à une seconde température pour augmenter encore la conductivité de la structure du cristal et du carbone.

5. Procédé selon les revendications 3 et 4, dans lequel l'étape de post-traitement thermique est une étape de post-traitement thermique à deux stades dans laquelle le premier stade est effectué dans une atmosphère gazeuse contenant un mélange d'un gaz inerte et d'un gaz réducteur à la première température, suivi par un second stade qui est effectué dans une atmosphère de gaz inerte à la seconde température, la seconde température étant plus élevée que la première température.

6. Procédé selon l'une quelconque des revendications précédentes, dans lequel le solvant est également sélectionné de telle façon qu'il fait office d'agent réducteur et d'agent de recouvrement qui réduit l'oxydation de M et qui recouvre les nanoparticules de la structure amorphe ou cristalline.

7. Procédé selon la revendication 6, dans lequel les nanoparticules recouvertes présentant des structures amorphes ou cristallines inhibent la croissance de structures cristallines de grande taille pendant le processus de post-traitement thermique, en limitant la taille moyenne des structures cristallines à la plage de 40 à 100 nm.

8. Procédé selon l'une quelconque des revendications précédentes, dans lequel le post-traitement thermique sert à assurer que les structures cristallines seront couvertes avec une couche de carbone ayant une épaisseur dans la plage de 1 à 10 nm.

9. Procédé selon la revendication 1, dans lequel la structure de carbone poreux a des pores d'une taille moyenne dans la plage de 2 à 5 nm.

10. Matériau d'électrode, comprenant des particules ayant la composition générale : AₐM_{b}(XY₄)_{c}, dans laquelle A est un métal alcalin, ou un métal alcalino-terreux, M est un métal de transition qui est capable de subir une oxydation vers un état à valence plus élevée, X est un élément parmi P, Si, Ge, B, S, As, Sb et leurs mélanges, et Y est un élément parmi O, OH, F, Cl, Br, I et leurs mélanges, lesdites particules étant revêtues avec un matériau comprenant du carbone et ayant une taille moyenne dans la plage de 40 à 100 nm, lesdites particules étant contenues dans une matrice de carbone poreux, et dans lequel le matériau d'électrode a un revêtement de carbone ayant une épaisseur dans la plage de 1 à 10 nm.

11. Matériau d'électrode selon la revendication 10, dans lequel A et un élément parmi Na, Li, K, Ca, Ag, Mg et leurs mélanges, et M est un élément parmi V, Fe, Mn, Co, Ti et Ni ou une combinaison de ceux-ci.

12. Matériau d'électrode selon la revendication 10 ou 11, comprenant en outre une aire de surface BET >100 m²/g, de préférence dans la plage de 100 à 250 m²/g.

13. Matériau d'électrode selon l'une quelconque des revendications 10 à 12, dans lequel la capacité du matériau d'électrode est supérieure à 70 et 40 mAh/g à un taux de courant 200 et 200C, respectivement, et la capacité peut être maintenue plus élevée que 50 mAh/g après 1000 cycles charge/décharge à un taux de 100C.

14. Véhicule comprenant une batterie ayant un matériau d'électrode susceptible d'être obtenu au moyen du procédé selon l'une quelconque des revendications 1 à 9.

15. Batterie ayant une cathode comprenant un matériau d'électrode susceptible d'être obtenu au moyen du procédé selon l'une quelconque des revendications 1 à 9, une anode, un électrolyte et un séparateur disposé entre l'anode et la cathode.
